# EUROPÄISCHE PATENTSCHRIFT

(11) **EP 0 812 930 B1**
(45) Veröffentlichungstag und Bekanntmachung des Hinweises auf die Patenterteilung: **04.12.2002**
(21) Anmeldenummer: 97108972.7
(22) Anmeldetag: 04.06.1997
(51) Int. Cl.: C23C 14/08, C23C 14/30

(54) **Keramische Verdampfermaterialien**
Ceramic evaporation material
Matériau céramique à évaporer

(30) Priorität: 13.06.1996 DE 19623587
(43) Veröffentlichungstag der Anmeldung: 17.12.1997
(73) Patentinhaber: Deutsches Zentrum für Luft- und Raumfahrt e.V., 53175 Bonn (DE)
(72) Erfinder: Leushake, Uwe, 70550 Stuttgart (DE); Luxem, Walter, 51147 Köln (DE); Kröder, Claus-Jürgen, 51147 Köln (DE); Zimmermann, Wolf-D., 51147 Köln (DE)
(74) Vertreter: Jönsson, Hans-Peter, Dr.Dipl.-Chem.

(56) Entgegenhaltungen:
- DE-A- 3 908 322
- DE-C- 4 302 167
- PATENT ABSTRACTS OF JAPAN vol. 017, no. 162 (C-1042), 30.März 1993 & JP 04 323366 A (ASAHI GLASS CO LTD), 12.November 1992,
- PATENT ABSTRACTS OF JAPAN vol. 016, no. 194 (C-0938), 11.Mai 1992 & JP 04 028865 A (MITSUBISHI KASEI CORP), 31.Januar 1992,

## Beschreibung

Gegenstand der Erfindung sind keramische Verdampfermaterialien (Ingots) für die Beschichtung von Oberflächen mittels physikalischer Abscheidung aus der Gasphase, ein Verfahren zu ihrer Herstellung sowie die Verwendung der keramischen Verdampfermaterialien zur Beschichtung von Gegenständen.

Die Beschichtung von Werkstoffen mittels Keramik hat in der jüngsten Vergangenheit in vielen verschiedenen Anwendungsbereichen an starker Bedeutung gewonnen. Auf diesem Wege können gezielte Eigenschaftskombinationen erreicht werden, die bei der Verwendung unbeschichteten Materials nicht möglich sind.

Für die verschiedenen Anwendungsbereiche haben sich unterschiedliche Beschichtungsverfahren etabliert, beispielsweise das thermische Spritzen oder das physikalische Abscheiden aus der Gasphase für die Herstellung dicker Schichten. Das physikalische Abscheiden aus der Gasphase (PVD) weist gegenüber den anderen Dickschichtverfahren Vorteile im Bereich der Abscheidung kontrollierter Mikrostrukturen dicker Schichten auf. In einer sich über einer überhitzten Schmelze ausbildenden Dampfwolke befindet sich das zu beschichtende Material (Substrat) und aufgrund des Temperaturunterschiedes kommt es zur Kondensation der Dampfphase. Noch in der Gasphase oder während der Kondensation der verdampften Teilchen kann es zu einer Reaktion mit dem vorhandenen Gas kommen (Reaktives Verdampfen). Dieses wird vorallem bei oxidischen Keramiken angewendet, um eine stöchiometrische Abscheidung der zum Teil stark dissozierenden Oxide zu erreichen. Für die Erzeugung der überhitzten Schmelze kann hochenergetische Strahlung, beispielsweise Laserstrahlung oder Elektronenstrahlung verwendet werden.

Das zu verdampfende Material muß in einer für den Prozeß geeigneten Form vorliegen. Bei kleineren Anlagen (Labormaßstab) wird das Material, oft als Granalien (grobes Pulver) in einem Tiegel liegend, verdampft. Diese Verfahrensvariante erfordert kaum eine besondere Aufbereitung des zu verdampfenden Materials, hat aber den entscheidenden Nachteil, daß kein gleichmäßiger und kontinuierlicher Beschichtungsvorgang über einen längeren Zeitraum möglich ist. Diese Kriterien sind jedoch für die industrielle Anwendung und die Herstellung dicker Schichten von entscheidender Bedeutung.

Für industrielle und semiindustrielle Anlagen wurde deshalb ein anderes Materialzuführungskonzept entwickelt. Das zu verdampfende Material wird zu runden Stäben (Ingots), beispielweise mit Durchmessern von 2 Zoll (≈ 50 mm) oder 2,5 Zoll (≈ 63 mm) und Längen von circa 25 cm, verarbeitet. Diese werden in einem seitlich führenden und unten offenen Tiegel an der Oberfläche aufgeschrnolzen und können über einen in der Beschichtungskammer integrierten Fördermechanismus kontinuierlich nachgeführt werden. Somit wird eine homogene und konstante Beschichtung von Gegenständen über einen längeren Zeitraum möglich.

Es zeigt sich jedoch, daß die Herstellung der Ingots und die sich daraus ergebenden Ingot-Eigenschaften einen deutlichen Einfluß auf das Verdampfungsverhalten der Ingots selber und die Qualität der abgeschiedenen Schichten haben. Für den Verdampfungsprozeß wird eine ruhige, nicht spritzende Schmelzbadausbildung gefordert. Die Schmelze sollte chemisch homogen sein, was sowohl durch die Verwendung von chemisch homogenisierten Pulvem als auch durch eine in der Schmelze stattfindende Homogenisierung (durch Konvektion) bei der Verwendung von inhomogenen Pulvern erreicht werden kann.

Als besonders kritisch für die Verwendung der Ingots haben sich die instationären Betriebsphasen (Aufheizen, Abkühlen Abkühlen und kurzzeitige Leistungsabschaltung durch Überschläge) erwiesen. In diesen Phasen kommt es durch den ausgeprägten Temperaturunterschied bei konventionellen dichten bzw. partiell gesinterten keramischen Materialien oft zum katastrophalen Versagen durch Bruch des Ingots. Aus diesem Grunde wird als eine Anforderung an das Ingot eine für diese Belastungen ausreichend hohe Thermoschockbeständigkeit definiert. Dies wird im allgemeinen durch eine ausreichende Restporosität realisiert.

Während der Beschichtung der Gegenstände finden im Ingot weitere Reaktionen statt. Die Verdampfungsrate beim PVD-Verfahren ist proportional zur Temperatur, und deshalb wird zum Erzielen hoher Beschichtungsraten angestrebt, das Schmelzbad möglichst hoch zu überhitzen (bis zu 4000°C). Aufgrund der geringen Wärmeleitfähigkeit der keramischen Werkstoffe entsteht in der unter dem Schmelzbad liegenden Zone ein steiler Temperaturgradient. Entsprechend laufen unterschiedliche Vorgänge in einem räumlich eng begrenzten Gebiet ab. Für den gesamten thermisch beanspruchten Bereich stellt sich, entsprechend der lokalen Temperatur, eine entsprechende lokale thermische Dehnung ein. Bei Temperaturen oberhalb der Sinterstarttemperatur kommt es durch Sintervorgänge zu einer gegenläufigen Volumenschrumpfung. Das Zusammenspiel dieser Mechanismen kann zum Versagen des Ingots während der Beschichtung führen.

Als weitere Anforderungen an das Ingot wird ferner eine konstante Dichte über die Ingothöhe gefordert. Aus maschinentechnischen Gründen müssen weiterhin bestimmte Forderungen an die Genauigkeit der Ingotgeometrie und die Handhabbarkeit (hier vor allem Grünfestigkeit) gestellt werden. Die Ingots werden im allgemeinen durch eine mechanische Bearbeitung (Drehen oder Rundschleifen) auf das gewünschte Maß gebracht.

Im Handel erhältlich sind nur Yttriumoxid (Y₂O₃)-teilstabilisierte Zirkonoxidingots, -die über ein aufwendiges Aufbereitungs- und Sinterverfahren hergestellt werden.

DE 43 02 167 C1 beschreibt ein Target aus Zirkonoxid und ein Verfahren zu seiner Herstellung. Zur Herstellung von Wärmedämmschichten auf Hochtemperaturwerkstoffen mittels Elektronenstrahlverdampfung (EB-PVD) werden Targets aus Zirkonoxid beschrieben, die thermoschockbeständig sein sollen. Solche Targets enthalten neben Zirkonoxid 0,5 bis 25 Gew.-% Yttriumoxid, beide mit einer Reinheit von wenigstens 99,8 %. Das Zirkonoxid muß zu 50 bis 80 Gew.-% als monokline Phase vorliegen und die Targets eine Sinterdichte von 3,0 bis 4,5 g/cm³ besitzen. Die Herstellung der Targets erfolgt durch Pressen und Sintem von Zirkonoxid/Yttriumoxidgemischen zu entsprechenden Formkörpern. Es wird als vorteilhaft beschrieben, Pulver zu verwenden, deren mittlere Partikelgröße d₅₀ unterhalb 50 µm liegt, wobei mehr als 90 Gew.-% der Teilchen 0,4 µm und größer und mehr als 50 Gew.-% 1 µm und größer sein müssen.

In der US-PS 4 676 994 wird eine dichte keramische Schicht auf Substraten beschrieben, wobei die Schicht eine Dichte von mehr als 94 % der theoretischen Dichte aufweist. Über das hier zu verwendende Target werden keine näheren Angaben gemacht.

Aus der DE 39 08 322 A1 sind Sinterkörper aus Zirkonoxid bekannt, die als Targets zum Aufdampfen optischer Schichten dienen. Das dort verwendete Zirkonoxid kann 50 bis 2000 ppm Calciumoxid enthalten und muß eine Reinheit von mindestens 99 % aufweisen. Außerdem müssen die Targets eine Dichte von mehr als 4,9 g/cm³ (80% relative Dichte) besitzen. Geringere Dichten sollen sich negativ auf die Qualität der aufgedampften Schichten auswirken. Bei Verwendung von 0.2 % Calciumoxid bilden sich Risse im Target, so daß keine stabilen Hochtemperaturphasen des Zirkonoxid mit diesen Targets erzeugt werden können, die für die Herstellung von Wärmedämmschichten erforderlich sind.

Der Begriff "Sintern" kennzeichnet einen wichtigen Verfahrensschritt in der Pulvermetallurgie. Dabei handelt es sich um eine thermische Verdichtung von Pulvern bzw. Pulverpresslingen über Diffusionvorgänge, in der Regel ohne Beteiligung schmelzflüssiger Phasen. Ein Sonderfall stellt hier das Flüssigphasensintern da. Die Sintertemperatur liegt in der Regel im Bereich von einhalb bis dreiviertel der Schmelztemperatur des niedrigst schmelzenden Materials. Phänomenologisch lassen sich drei Stadien des Sinterns unterscheiden:
1. Wachstum der Teilchenkontakte durch Bildung sogenannter Sinterbrücken.
2. Ausbildung eines zusammenhängenden Porenskeletts. Die ursprünglichen Teilchen verlieren ihre Identität, es erfolgt Schwindung und Ausbildung neuer Komgrenzen.
3. Porenrundung und -eliminierung mit weiterer Schwindung. Verbleibender Porenraum wird zunehmend von außen unzugänglich (geschlossene Poren). Im Grenzfall erfolgt vollständige Verdichtung.

Zur Vermeidung von Oxidationen kann dieser Vorgang unter Schutzgasatmosphäre oder im Vakuum durchgeführt werden. Das Sintem ist ein Verfahrensschritt, der sowohl für Metalle als auch für Keramiken Anwendung findet. Er unterscheidet sich gegenüber der Verdichtung durch Pressen durch die Ausbildung von Festkörperbrücken über Diffusion, wobei sowohl Oberflächen-, Komgrenzen- und Volumendiffusion eine Rolle spielen können. Je nach Sintertemperatur und Aktivierungsemergie der entsprechenden Diffusionswege tragen die unterschiedlichen Mechanismen zur Verdichtung bei.

Die Erhöhung der Wirkungsgrade von Verbrennungsmotoren oder auch Turbinen läßt sich nur über eine erhöhte Verbrennungstemperatur realisieren. Aktuelle Forschungsarbeiten zeigen deshalb Entwicklungen zu neuen und komplexeren Schichtsystemen im Bereich der thermischen Schutzschichten auf. Das umfaßt sowohl die Verwendung anderer Stabilisatoren für das bisher konventionell verwendete Yttriumoxid stabilisierte Zirkonoxid als auch die Entwicklung komplett neuer keramischer thermischer Schutzschichten. Somit gewinnt die Herstellung von Ingots entsprechender chemischer Zusammensetzung an grundlegender Bedeutung für diese Entwicklung und deren spätere industrielle Umsetzung. Erst durch die Entwicklung neuer Aufbereitungsverfahren ist die Grundlage für die weiteren Aktivitäten in diesem Bereich geschaffen worden.

Das Herstellungsverfahren der zur Zeit kommerziell erhältlichen teilstabilisierten Zirkonoxid-Ingots läßt sich aufgrund der durchgeführten pulver- und werkstoffspezifischen Sinterbehandlungen nicht auf andere chemische Zusammensetzungen oder keramische Materialien erweitern und ist aufgrund der Vielzahl von durchgeführten . Sinter- und Calcinierungsbehandlungen sehr komplex und kostenintensiv.

Die Aufgabe der vorliegenden Erfindung besteht somit in der Bereitstellung von kostengünstig herstellbaren thermoschockbeständigen keramischen Verdampfermaterialien (Ingots) mit einer definierten chemischen Zusammensetzung, die bedingt durch die Auswahl an möglichen Ausgangsmaterialien, eine große Vielfalt.im Hinblick auf die chemische Zusammensetzung der Beschichtungsmaterialien erlaubt.

Die vorgenannte Aufgabe wird gelöst in einer ersten Ausführungsform durch keramische Verdampfermaterialien (Ingots) für die Beschichtung von Gegenständen mittels physikalischem Abscheiden aus der Gasphase, dadurch erhältlich, dass man ein Gemisch wenigstens zweier Pulverfraktionen aus 50 bis 90 Vol.-% eines grobkörnigen Pulvers und 10 bis 50 Vol.-% eines feinkörnigen Pulvers, wobei der mittlere Partikeldurchmesser d₅₀ des feinkörnigen Pulvers höchstens ein Drittel des mittleren Partikeldurchmessers des grobkörnigen Pulvers beträgt bei Raumtemperatur axial presst und anschließend isostatisch nachverpresst oder das Gemisch isostatisch presst.

Der Kern der vorliegenden Erfindung basiert auf einer speziellen Pulveraufbereitung. Das zu verdampfende Material muss in wenigstens zwei definiert unterschiedlichen Pulverfraktionen vorliegen. Beide Pulver sollten eine möglichst enge Streubreite der jeweiligen Partikelgröße aufweisen. Ein Pulver sollte einen möglichst großen mittleren Partikeldurchmesser aufweisen, das Andere einen möglichst geringen Durchmesser.

Bei der Mischung bimodaler Pulver (Pulver mit zwei unterschiedlichen Partikelgrößenverteilungen) lassen sich bei bestimmten Mischungsverhältnissen der Pulver untereinander Preßlingsgründichten, die höher sind als die Gründichten der jeweiligen Ausgangspulver, erreichen. Dies basiert auf einer Einlagerung der kleineren Pulverpartikel in die Zwischenräume der sich berührenden größeren Partikel. Somit lassen sich relative Preßlingsgründichten einstellen, die sonst nur über partielle Sinterbehandlungen zu erreichen sind. Über das Mischungsverhältnis der einzelnen Pulver zueinander läßt sich ferner die Gründichte in einem weiten Dichtebereich variieren und somit den Anforderungen für die konventionellen Ingots entsprechend anpassen. Aufgrund der Vielseitigkeit des Verfahrens lassen sich sich viele unterschiedliche Pulver aneinander anpassen und entsprechend aufbereiten. Aus diesem Grunde ist es nicht möglich das Verhältnis der Pulvergrößen nach oben zu begrenzen. Theoretisch ist sogar ein unendlich großes Verhältnis der beiden Pulverpartikelgrößen erstrebenswert. Im Falle der Mischung von mehr als zwei Pulverfraktionen (polymodale Partikelgrößenverteilung) sind die Mengenanteile der Mischungsverhältnisse der Zahl der Pulverfraktionen anzupassen.

Die beiden Pulver müssen über einen nassen oder trockenen Mahl/Mischvorgang homogenisiert werden, wobei möglichste keine Veränderung der vorher eingestellten Partikelgrößenverteilung stattfinden sollte (geeignete Wahl des Mahl/Mischverfahrens und Parameter). Zum Zwecke der homogeneren Verpreßbarkeit kann der Pulvermischung im ausreichenden Maße Preßhilfsmittel im flüssigen bzw. festem Zustand zugegeben werden. Bei der Verwendung von flüssigen Suspensionen muß dieses nach dem Mischen durch ein geeignetes Verfahren wieder entzogen werden. Die bimodale Pulvermischung wird vor der Formgebung gesiebt und anschließend fließfertig granuliert. Neben der homogeneren Verpreßbarkeit vermeidet die Verwendung von Preßhilfsmitteln auch die Trennung der einzelnen Pulverfraktionen.

Die Formgebung erfolgt entweder durch axiales Pressen mit anschließender isostatischer Nachverdichtung oder direkt über isostatisches Pressen. Aufgrund der fehlenden plastischen Verformung keramischer Pulver führt eine Variation der Formgebungsparameter nur zu einer geringfügigen Beeinflussung der Gründichte. Limits ergeben sich dadurch, daß ein zu hoher Preßdruck aufgrund von Überpressungen sich negativ auf das Verhalten der Ingots auswirkt, bei einem zu geringen Preßdruck erreicht man nicht die für die weitere Handhabung erforderliche Grünfestigkeit. Es ist deshalb notwendig, den Preßdruck den Anforderungen und der Geometrie entsprechend zu optimieren. Bei der Herstellung flacher Ingots (Höhe < Durchmesser) empfiehlt sich die Kombination von axialer und isostatischer Formgebung. Bei hohen Ingots empfiehlt sich die direkte isostatische Formgebung um die negativen Effekte von Werkzeugreibung zu vermeiden.

Nachfolgend kann der Preßling mechanisch auf das gewünschte Maß bearbeitet werden, wobei hier entweder die Bearbeitung mittels Rundschleifmaschinen oder Drehen möglich ist. Die Grünfestigkeit der Ingots ist, insbesondere durch die verwendeten Preßhilfsmittel, für eine mechanische Bearbeitung ausreichend.

Abschließend muß durch eine Wärmebehandlung, gegebenenfalls unter Vakuum, das gegebenenfalls zugefügte Preßhilfsmittel wieder entzogen werden, wobei hier deutlich unterhalb der Sinterstarttemperatur geglüht werden muß. Die Temperatur und Temperaturführung wird so gewählt, daß die zugegebenen Preßhilfsmittel verdampfen und aus dem Preßling ohne Schädigung desselben austreten können.

Die besonderen Vorteile der vorliegenden Erfindung liegen darin, daß
- das Prinzip sich über eine Vielzahl zur Verdampfung in Frage kommenden keramischen Materialien übertragen läßt,
- sinterlose Herstellung bei Raumtemperatur einfach ist,
- aufgrund der fehlenden Sinterbrücken sich weitere Vorteil ergeben:
   - auftretende Volumenänderungen durch Phasenumwandlungen bedingen nicht das Versagen des Ingots und deshalb muß die Phasenzusammensetzung der verwendeten Pulver nicht näher spezifiziert werden
   - geringere Wärmeleitfähigkeit des Ingots und somit bessere Schmelzbadkontrolle
   - geringere Wärmeleitfähigkeit führt zu geringeren thermischen Verlusten
   - Verringerung der entstehenden thermischen Spannungen während der stationären und instationären Betriebsphasen durch das Ablösen oder Verschieben der Pulverpartikel untereinander
   - Verringerung beziehungsweise Stoppen des Rißwachstums
   - die Thermoschockbeständigkeit wird nur unwesentlich von der Dichte beeinflußt
- die Verwendung gröberer Pulverpartikel zu einer Verringerung der Sintemeigung der thermisch hoch beanspruchten Zone führt und somit die dadurch entstehende Spannung verringert.

Eine bevorzugte Ausführungsform der erfindungsgemäßen keramischen Verdampfermaterialien ist dadurch gekennzeichnet, daß das Gemisch wenigstens zweier Pulverfraktionen grobkörniges Pulver in einer Menge von 60 bis 85 Vol.-% und feinkörniges Pulver in einer Menge von 15 bis 40 Vol.-% umfaßt. Innerhalb dieses Mengenbereiches sind besonders gute keramische Verdampfermaterialien herzustellen, die eine sehr hohe relative Dichte aufweisen und somit geeignet sind, eine große Menge an zu verdampfendem Material zur Verfügung zu stellen.

Bei den Verdampfermaterialien des Standes der Technik spielt die relative Dichte des Ingots eine entscheidende Rolle, da über eine ausreichende Restporosität die notwendige Thermoschockbeständigkeit eingestellt wird. So ist es im Stand der Technik nicht üblich, keramische Verdampfermaterialien mit relativen Dichten von mehr als etwa 60 bis 70 % herzustellen. Mit Hilfe der vorliegenden Erfindung ist es jedoch möglich, relative Dichten von 50 bis 80 %, insbesondere 70 bis 80 % zu erreichen. Diese hohen relativen Dichten sind dadurch erhältlich, daß das feinkörnige Pulver in Hohlräume des grobkörnigen Pulvers eindringt und so die relative Gründichte der erfindungsgemäßen keramischen Materialien auf einen Bereich einstellbar ist, die oberhalb der relativen Gründichten der einzelnen Pulver liegt.

Ein weitere bevorzugte Ausführungsform der erfindungsgemäßen keramischen Verdampfermaterialien ist dadurch gekennzeichnet, daß der mittlere Partikeldurchmesser d₅₀ des feinkörnigen Pulvers höchstens ein Fünftel bis ein Zwanzigstel, insbesondere ein Zehntel des mittleren Partikeldurchmessers des grobkörnigen Pulvers beträgt.

Die Teilchen liegen im nm, µm oder mm-Bereich üblicherweise als monodisperses Pulver vor, so daß eine Verteilungsdichtekurve gegeben ist, die durch einen minimalen Durchmesser der Teilchen und einem maximalen Durchmesser der Teilchen gekennzeichnet ist. Besonders bevorzugt im Sinne der vorliegenden Erfindung werden die absoluten Partikeldurchmesser des grobkörnigen Pulvers derart eingestellt, daß diese weniger als 20 %, insbesondere weniger als 10 % Überlappung mit dem absoluten Partikeldurchmesser des feinkörnigen Pulvers aufweisen. Dabei ist es gegebenenfalls möglich, Teilchen ausschließlich aus feinkömigem Pulver zu verwenden, wobei ein Teil des feinkörnigen Pulver in einem separaten Verfahrensschritt speziell aufbereitet wird. Hierbei ist es gegebenenfalls möglich, den Teil des Pulvergemisches, der den grobkörnigen Pulveranteil darstellt, in einem separaten Vorbehandlungsschritt zu sintern, um ein der Spezifikation entsprechendes grobkörniges Pulver zu erhalten.

Bedingt durch den Einsatz eines bimodalen Pulvers ist es möglich, daß erfindunggemäß das grobkörnige Pulver und das feinkömige Pulver gleiche oder unterschiedliche chemische Zusammensetzungen aufweisen können. So ist es möglich, beispielsweise beide Pulver aus Zirkonoxid (unstabilisiert/teilstabilisiert/vollstabilisiert) herzustellen durch entsprechendes Vermischen verschiedener Pulverfraktionen. In gleicher Weise ist es jedoch auch möglich, unterschiedliche keramische Materialien in die unterschiedlichen Pulverfraktionen einzubringen, um somit chemisch unterschiedliche Pulver zusammen in eine homogene Mischung einzubringen. Prinzipiell ist es in diesem Sinne darüber hinaus möglich, inhomogene Pulvergemische zur Verfügung zu stellen, die die Möglichkeit bieten, innerhalb eines einzigen keramischen Verdampfermaterials Gradientenbeschichtungen auf Oberflächen aufzubringen. Durch unterschiedliche chemische Zusammensetzung entlang der Länge der Ingots läßt sich eine entsprechende Beschichtung erreichen.

Im Sinne der vorliegenden Erfindung können praktisch alle bekannten keramischen Materialien eingesetzt werden. Insbesondere sind an dieser Stelle zu erwähnen die Metall- und/oder Übergangsmetall-Oxide, - Nitride, -Carbide, -Boride und/oder-Silicide. In dem eingangs erwähnten Stand der Technik wird dokumentiert, daß Zirkonoxid eine Phasenumwandlung (monoklin-tetragonal) durchläuft, die eine große Volumenänderung im Temperaturbereich von 900 bis 1200 °C bedingt (3-5%), weshalb es im Stand der Technik als schwierig dargestellt wird, hochdichte Sinterkörper größerer Geometrie aus reinem Zirkonoxid herzustellen. Erfindungsmäß gelingt jedoch die Herstellung von nicht stabilisiertem, beispielsweise Yttriumoxid-freiem, Zirkonoxidingots mit relativen Gründichten im Bereich von 60 bis 80 %, da die erfindungsgemäßen keramischen Verdampfermaterialien (Ingots) beim Herstellungsverfahren keiner Sinterung unterliegen und diese Phasenumwandlung somit nicht auftritt. Beim Einsatz der Ingots zu Beschichtungszwecken wird dann aufgrund der äußerst schlechten Wärmeleitfähigkeit nur die Oberfläche der Ingots angeschmolzen. In den darunterliegenden tieferen Schichten sind die Pulverpartikel aufgrund der fehlenden Sinterbrücken mehr oder weniger frei gegeneinander beweglich, so daß bei Auftreten kleinster Bruchstellen, diese nicht weiter reißen bzw. gestoppt werden.

Eine weitere Ausführungsform der Erfindung besteht in dem Verfahren zur Herstellung von keramischen Verdampfermaterialien wie eingangs definiert. Hierzu wird insbesondere ein homogenes Gemisch von grobkömigem Pulver und feinkörnigem Pulver, gegebenenfalls unter Einsatz von Preßhilfsmitteln verpreßt, der Rohling mechanisch auf das gewünschte Maß bearbeitet und gegebenenfalls vorhandene Preßhilfsmittel durch eine Wärmebehandlung unterhalb der Sinterstarttemperatur unterzogen. Von besonderer Bedeutung bei der Realisierung des Herstellungsverfahrens ist die schonende Temperaturführung zum Entziehen der Preßhilfsmittel, die deutlich unterhalb der Sinterstarttemperatur der verwendeten Pulver liegt. Durch Wahl der geeigneten Druck- und Temperaturbedingungen läßt sich die Sinterung der eingesetzten keramischen Materialien zweifelsohne vermeiden und ein vollständiger Entzug der Preßhilfsmittel garantieren.

In einer besonderen Ausführungsform der vorliegenden Erfindung wird das Gemisch aus grobkömigem und feinkörnigem Pulver zunächst bei Raumtemperatur axial gepreßt und anschließend isostatisch nachverpreßt. Das isostatische Pressen ist bekanntermaßen eine Alternative gegenüber dem axialen Pressen, bei dem aufgrund innerer Spannungen und Werkzeugreibung im Pulver eine ungleichmäßige Verdichtung des Formkörpers auftritt, die sich sowohl in axialer als auch radialer Richtung erstreckt. Bei der isostatischen Formgebung erfolgt die Wahl der ungefähren Formgebung über eine entsprechende elastische Grundform. Diese wird im verschlossenen und evakuierten Zustand dann in einem Flüssigkeitsbehälter einem allseitig gleichem Druck ausgesetzt, was zu einer gleichmäßigen Verdichtung und symmetrischen Schwindung des Werkstoffs führt. Da die Form aus einem elastischen Material, meist Latex, besteht und sich druckelastisch verhält, das heißt nachgiebig, ist die Rohteil-Geometrie im Gegensatz zum Trockenpressen an den Oberflächen, insbesondere am äußeren Rand nicht exakt definiert Der Grünkörper (geformter Körper, ungesintert) wird aus diesem Grunde maschinell nachbearbeitet, seine Festigkeit und seine Härte sind zu diesem Zeitpunkt für die entsprechenden Behandlung ausreichend.

Alternativ zu dem sequentiellen Pressen, das ausgeht von einem axialen Verpressen bei Raumtemperatur und anschließendem isostatischen Pressen, ist es auch möglich, die Ingots direkt durch isostatisches Pressen herzustellen.

Besonders bevorzugt im Sinne der vorliegenden Erfindung ist die Verwendung von an sich im Stand der Technik bekannten Preßhilfsmitteln. Hierbei sind an erster Stelle Wachse, Seifen und hochviskose Flüssigkeiten usw. zu erwähnen, die insbesondere in einer Menge von bis zu 10 Gew.-Teilen, vorzugsweise 2 bis 6 Gew.-Teilen bezogen auf das Pulvergemisch, eingesetzt werden. Diese Preßhilfsmittel werden dem Ingot durch eine geeignete Wärmebehandlung deutlich unterhalb der Sinterstarttemperatur der keramischen Pulver entzogen.

Eine weitere Ausführungsform der vorliegenden Erfindung besteht in der Verwendung von keramischen Verdampfermaterialien, wie eingangs definiert, zur Beschichtung von Gegenständen, insbesondere im optischen Bereich oder im Turbinenbau, sowohl fliegende als auch stationäre Turbinen, durch Einwirkung hochenergetischer Strahlung.

Zur Verbesserung des Wirkungsgrades für moderne Triebwerke wird eine Verringerung des Treibstoffverbrauches angestrebt. Eine Möglichkeit hierfür besteht in der Erhöhung der Verbrennungstemperatur in der Brennkammer. Diese konnte in der Vergangenheit durch Legierungsentwicklungen und Kühlung von Komponenten kontinuierlich gesteigert werden. Die Nickel-Superlegierungen finden im Turbinenbau im Bereich der hochbelasteten Komponenten ihre Anwendung und werden bei Temperaturen von bis zu 95% ihres Schmelzpunkts eingesetzt. Im Stand der Technik bekannt sind Beschichtungen dieser Turbinenschaufeln aus keramischen Materialien mit extrem geringer Wärmeleitfähigkeit (1 bis 2 Wm⁻¹), die als Wärmedämmschichten außen auf die Turbinenschaufeln angebracht werden und diese somit ummanteln. Die Dicke dieser Schichten beträgt beispielsweise 0,1 bis 0,3 mm, wodurch sich eine Temperaturabsenkung des metallischen Substrat um 100 bis 200°C erzielen läßt. Als Beschichtungsmaterial wird bevorzugt Zirkonoxid verwendet, das eine hohe Wärmedämmung und eine der Nickelsuperlegierung ähnliche thermische Ausdehnung aufweist. Erfindungsgemäß ist die Stabilisierung von Zirkonoxid zur Verwendung in diesen Beschichtungen nicht erforderlich. Mittlerweile finden auch thermische Schutzschichten Anwendung bei stationären Gasturbinen. In gleicher Weise läßt sich das keramische Verdampfermaterial auch im optischen Bereich, insbesondere zur Beschichtung von Brillengläsern einsetzen.

### Ausführungsbeispiele

In den nachfolgend aufgeführten Ausführungsbeispielen soll die Anwendbarkeit des entwickelten Verfahrens auf die Herstellung von zur Zeit kommerziell erhältlichen teilstabilisierten Zirkonoxidingots und neuen chemischen Zusammensetzungen beschrieben werden.

### Beispiel 1

In diesem Ausführungsbeispiel wird die Herstellung eines Zirkonoxidingots mit 3 Mol.-% Yttriumoxid und einem durch die Pulverherstellung bedingten Gehalt an Hafniumoxid (weniger als 2 Mol.-%) beschrieben. Es handelt sich hierbei um eine den kommerziell erhältlichen Ingots ähnliche chemische Zusammensetzung, der Stabilisatorgehalt liegt allerdings etwas niedriger.

Die für die Mischungen verwendeten handelsüblichen Pulvern (A) und (B) wiesen eine unterschiedliche chemische Zusammensetzung auf. Das erste, zunächst noch feine Pulver (A) mit einer mittleren Partikeldurchmesser d₅₀=0.3 µm (BET 16m²/g), enthält 4 Mol% Yttriumoxid, das feine Pulver (B) ist unstabilisiert mit einer einer mittleren Partikeldurchmesser d₅₀=0.3 µm (BET 12m²/g). Diese Pulver (B) zeichneten sich gegen gegenüber den meisten erhältlichen Zirkonoxidpulvern durch einen geringen Gehalt an Hafniumoxid aus, der auf das unterschiedliche Herstellungsverfahren und Ausgangsmaterialien zurückzuführen ist.

Das verwendete grobe Pulver wurde selbst hergestellt. Aus dem durch das vom Hersteller durchgeführte Sprühtrocknen, kugelförmig vorliegenden Pulver (A) konnte durch Sintern einer losen Schüttung bei 1450 °C/1 Stunde/Luft ein grobes Pulver (A*) mit einem mittleren Partikeldurchmesser d₅₀=51.8 µm hergestellt werden.

Als erster Schritt für die Herstellung der Ingots wird generell der Einfluß des Pulvermischungsverhältnisse auf die Gründichte von Preßlingen untersucht. Das Processing soll hier beispielhaft beschrieben werden. Für die Voruntersuchungen wurden jeweils 20 Gramm der entsprechenden Pulvermischung aufbereitet und entsprechend kleine Preßlinge (2-5 Gramm) hergestellt Für die Formgebung wurde eine fliegende Matrize mit 16.5 mm Durchmesser verwendet.

Die jeweiligen Pulvermischungen und Preßhilfsmittel (1 Gew-Teile SS, 1 Gew-Teile ST, 2 Gew-Teile PEG 600, 2 Gew-Teile EP (Produktbezeichnung der Hersteller)) wurden in einer alkoholischen Lösung (Isopropanol) naß gemischt. In diesem Falle erfolgte das Mischen mittels Ultraturrax, kann aber auch bei der entsprechenden Wahl der Mahlparameter in Kugelmühlen bzw. Planetenmühlen durchgeführt werden. Anschließend wurde die Pulversuspension im Rotationsverdampfer unter Vakuum getrocknet, gesiebt und im Taumelmischer granuliert. Die Preßlinge wurden bei 50 MPa axial vorgepreßt und anschließend in evakuierten Latexhüllen bei 200 MPa isostatisch nachverdichtet. Die Gründichte für unterschiedliche Pulvermischungen wurde nach dem Entzug der Preßhilfsmittel bestimmt und ist in der Tabelle 1 wiedergegeben. Es zeigte sich, daß für einen großen Mischungsbereich die bei den kommerziell erhältlichen Ingots eingestellte Dichte schon als Preßlingsgründichte erreicht werden kann. Hierbei ist jedoch zu beachten, daß sich ein vom Pulvermischungsverhältnis abhängiger Yttriumoxidgehalt des Ingots ergab.

**Tabelle 1**

| Mengen grobkörniges Pulver [Vol.%] | Mengen feinkörniges Pulver [Vol.%] | absolute Gründichte [g/cm³] | relative Gründichte % |
|---|---|---|---|
| 0* | 100 | 3.00 | 49.6 |
| 50 | 50 | 3.77 | 62.3 |
| 65 | 35 | 4.03 | 66.6 |
| 75 | 25 | 4.14 | 68.5 |
| 85 | 15 | 4.09 | 67.5 |
| 95* | 15 | 3.94 | 65.1 |

| | | | |
|---|---|---|---|
| ***Vergleichsbeispiele** | | | |

Für die Herstellung eines Ingots wurden 200 g einer Pulvermischung aus 65 Vol.% grobkörnigem Pulver (A*) und 35 Vol.% feinkörnigem Pulver (B) und Presshilfsmittel (6 Gew.% Wachs) gemäß dem oben beschriebenen Processings aufbereitet. Diese Pulvermischung wurde in einer fliegenden Matrize (Durchmesser 55 mm) axial vorgepresst und anschließend isostatisch nachverdichtet. Für das Ingot ergab sich eine relative Gründichte von 65 %. Die Abweichung der Gründichte im Vergleich zu den vorher durchgeführten Versuchen ist durch das andere Durchmesser/Höhenverhältnis während des Pressens zu erklären.

Nach der mechanischen Bearbeitung mittels Drehen wurden dem Ingot die Presshilfsmittel durch eine Wärmebehandlung an Luft entzogen (in 900 min auf 450°C, 2 Std. halten, freie Ofenabkühlung). Unter den für die Verdampfung von Yttriumoxid teilstabilisiertem Zirkonoxid üblichen Parametern wurden mit dem Ingot Probeverdampfungen durchgeführt, welche sehr zufriedenstellend verliefen. Das Ingot wurde mehrmals aufgeheizt und abgekühlt und zeigte sich thermoschockbeständig. Das Schmelzbad selber war ruhig und spritzerfrei.

### Beispiel 2

In Ausführungsbeispiel 2 soll die Herstellung eines unstabilisierten Zirkonoxidingots beschrieben werden. Diese Qualität ist zur Zeit nicht kommerziell erhältlich. Es wurden zwei verschiedene unstabilisierte kommerziell erhältliche Zirkonoxidpulver verwendet, die sich insbesondere durch sehr geringe Hafniumoxidgehalte (<100 ppm) auszeichnen. Das grobe Pulver wies im Anlieferungszustand eine spezifische Oberfläche von 6,4 m²/g mit einem mittleren Partikeldurchmesser d₅₀= 0.57 µm auf. Aus diesem Ausgangspulver wurde durch Sintem bei 1450°C/1h in Luft ein gröberes Pulver (A*) hergestellt. Aufgrund der länglichen Partikelausbildung nach dem Sintern konnte die mittlere Partikelgröße nach dem Sintern mittels Lasergranulometer und Sieben nicht exakt bestimmt werden, wurde jedoch zu wenigstens 98,3 µm angenommen. Die spezifische Oberfläche war jedoch kleiner als 0,5 m²/g. Das feine Pulver (B) war gekennzeichnet durch eine spezifische Oberfläche von 12 m²/g bzw. einem mittleren Partikeldurchmesser d₅₀= 0.30 µm. In Analogie zu Beispiel 1 wurden 200 g einer Pulvermischung (65 % grobes gesintertes Pulver (A*) und 35 % feines Pulver (B) aufbereitet und zu einem Ingot gepreßt. Diese Pulvermischung wurde mit einem axialen Preßdruck von rund 40 MPa vorgepreßt und anschließend bei 200 MPa isostatisch nachverdichtet. Bei dem verwendeten Matrizendurchmesser von 55 mm ergab sich nach der Formgebung ein Ingotdurchmesser von 49,1 mm, so daß auf eine weitere spanende Formgebung verzichtet werden konnte. Durch eine anschließende Wärmebehandlung (in 900 min auf 450°C, 2 Std. halten, freie Ofenabkühlung) wurden die Preßhilfsmittel entzogen und die relative Dichte des Ingots zu 59 % bestimmt.

Basierend auf den für die Verdampfung von teilstabilisierten Zirkoniumdioxid ermittelten Parametern wurde ein Verdampfungsversuch durchgeführt. Das Verhalten während der Verdampfung war gut, das Schmelzbad ruhig und spritzerfrei. Das Ingot erwies sich als sehr thermoschockbeständig, so daß es den durch auftretende Elektronenstrahlkanonenausfälle, beziehungsweise Überschläge bedingte, schnellen Abkühlen und anschliessenden Aufheizen ohne Probleme standhielt.

### Beispiel 3

Durch die Herstellung und erfolgreiche Verdampfung eines Aluminiumoxidingots konnte der allgemeine, das heißt werkstoffunabhängige Charakter des entwickelten Herstellungsverfahrens unterstrichen werden. Es wurden in Analogie zu Beispiel 1 und 2 ebenfalls zwei verschiedene Ausgangspulver verwendet. Bei dem feinen Pulver (B) handelte es sich um ein hochreines Aluminiumoxid mit einer spezifischen Oberfläche von 9 bis 12 m²/g und mit einem mittleren Partikeldurchmesser d₅₀= 0.6 µm.

In Analogie zu Beispiel 1 und 2 wurde das zweite Pulver zwecks Vergröberung noch einer zusätzlichen Glühung unterzogen. Ausgehend vom Pulvertyp (A) (reines Aluminiumoxid, BET= 0,8 bis 1,2 m²/g) wurde durch Glühung einer losen Pulverschüttung bei 1450°C/1 Stunde / Luft die grobe Pulverfraktion (Ag) hergestellt. Das geglühte Pulver wies einen mittleren Partikeldurchmesser d₅₀=22.0 µm auf.

Es wurden aus 130 g (65 %) des groben Pulvers (Ag)(1450°C/1h), 70 g (35 %) des feinen Pulvers (B) und 6 Gew.-Teilen Preßhilfsmittel (Wachs) eine Pulvermischung in Analogie zu Beispiel 1 hergestellt. Das aufbereitete Pulver wurde mit einem axialen Preßdruck von rund 40 MPa vorgepreßt und anschließend bei 200 MPa isostatisch nachverdichtet. Bei dem verwendeten Matrizendurchmesser von 55 mm ergab sich nach der Formgebung ein Ingotdurchmesser von 48,8 mm, so daß auf eine spanende Formgebung verzichtet werden konnte. Durch eine anschließende Wärmebehandlung an Luft (in 900 min auf 450°C, 2 Std. halten, freie Ofenabkühlung) wurden die Preßhilfsmittel vollständig entzogen und die relative Dichte des Ingots zu 63 % bestimmt.

Basierend auf den Erfahrungen im Bereich des Verdampfens von Zirkonoxid wurden neue Parameter für das Verdampfen von Aluminiumoxid entwickelt. Dieses wurde notwendig durch das unterschiedliche Verdampfungsverhalten von Aluminiumoxid im Vergleich zum Zirkonoxid, was schon im deutlich geringeren Schmelzpunkt zum Ausdruck kommt. Das wie oben beschriebene hergestellte Ingot wurde Probenverdampfungen unterzogen. Das sich ausbildende Schmelzbad war im allgemeinen ruhig, es trat aber eine geringe Anzahl an gutmütigen Blasen auf (das heißt langsames Auftauchen, minimale Spritzerbildung). Nach dem Abkühlen wies der Ingot im Bereich des ehemaligen Schmelzbades eine glasartig erstarrte Oberfläche mit einem feinen Rißnetzwerk auf. Weiter unterhalb traten einige größere Risse auf, die jedoch nicht zu einem katastrophalen Versagen des Ingots führten und somit unkritisch waren. Trotz der gegenüber dem Zirkonoxid um eine Größenordnung größeren Wärmeleitfähigkeit war der sich ausbildende Schmelzsumpf klein, was auf die deutliche Verringerung der Wärmeleitfähigkeit durch die Porosität und insbesondere die fehlenden Feststoffverbindungen, wie sie ansonsten nach dem Sintern vorliegen, zurückzuführen ist.

## Patentansprüche

1. Keramische Verdampfermaterialien (Ingots) für die Beschichtung von Gegenständen mittels physikalischem Abscheiden aus der Gasphase, **dadurch erhältlich, dass man** ein Gemisch wenigstens zweier Pulverfraktionen aus 50 bis 90 Vol.-% eines grobkörnigen Pulvers und 10 bis 50 Vol.-% eines feinkörnigen Pulvers, wobei der mittlere Partikeldurchmesser d₅₀ des feinkörnigen Pulvers höchstens ein Drittel des mittleren Partikeldurchmessers des grobkörnigen Pulvers beträgt **bei Raumtemperatur axial presst und anschließend isostatisch nachverpresst oder das Gemisch isostatisch presst.**

2. Keramische Verdampfermaterialien nach Anspruch 1, **dadurch gekennzeichnet, dass** das Gemisch grobkörniges Pulver in einer Menge von 60 bis 85 Vol.-% und feinkörniges Pulver in einer Menge von 15 bis 40 Vol.-% umfasst.

3. Keramische Verdampfermaterialien nach Anspruch 1 oder 2, **dadurch gekennzeichnet, dass** die relative Gründichte 50 bis 80 %, insbesondere 70 bis 80% beträgt.

4. Keramische Verdampfermaterialien nach einem oder mehreren der Ansprüche 1 bis 3, **dadurch gekennzeichnet, dass** der mittlere Partikeldurchmesser d₅₀ des feinkörnigen Pulvers höchstens ein Fünftel bis ein Zehntel des Partikeldurchmessers des grobkörnigen Pulvers beträgt.

5. Keramische Verdampfermaterialien nach einem oder mehreren der Ansprüche 1 bis 4, **dadurch gekennzeichnet, dass** die absoluten Partikeldurchmesser des grobkörnigen Pulvers weniger als 20 %, insbesondere weniger als 10 % Überlappung mit dem absoluten Partikeldurchmesser des feinkörnigen Pulvers aufweisen.

6. Keramische Verdampfermaterialien nach einem oder mehreren der Ansprüche 1 bis 5, **dadurch gekennzeichnet, dass** die chemische Zusammensetzung des grobkörnigen Pulvers der chemischen Zusammensetzung des feinkörnigen Pulvers entspricht.

7. Keramische Verdampfermaterialien nach einem oder mehreren der Ansprüche 1 bis 5, **dadurch gekennzeichnet, dass** die chemische Zusammensetzung des grobkörnigen Pulvers ungleich der chemischen Zusammensetzung des feinkörnigen Pulvers ist.

8. Keramische Verdampfermaterialien nach einem oder mehreren der Ansprüche 1 bis 7, **dadurch gekennzeichnet, dass** die chemische Zusammensetzung der Pulver ausgewählt ist aus Metall- und/oder Übergangsmetall-Oxiden, - Nitriden, -Carbiden, - Boriden und/oder -Siliciden.

9. Keramische Verdampfermaterialien nach Anspruch 8, **dadurch gekennzeichnet, dass** das Pulver aus nicht stabilisiertem, insbesondere Yttriumoxid-freiem Zirkonoxid besteht.

10. Keramische Verdampfermaterialien nach Anspruch 8, **dadurch gekennzeichnet, dass** das Pulver aus Aluminiumoxid besteht.

11. Verfahren zur Herstellung von keramischen Verdampfermaterialien nach einem oder mehreren der Ansprüche 1 bis 10, **dadurch gekennzeichnet, dass** insbesondere homogene Gemische von grobkörnigem Pulver und feinkörnigem Pulver verpresst, der erhaltene Rohling mechanisch auf das gewünschte Maß bearbeitet.

12. Verfahren nach Anspruch 11, **dadurch gekennzeichnet, dass** man Presshilfsmittel einsetzt und vorhandene Presshilfsmittel durch eine Wärmebehandlung unterhalb der Sinterstarttemperatur verflüchtigt.

13. Verfahren nach Anspruch 11 oder 12, **dadurch gekennzeichnet, dass** man das Gemisch bei Raumtemperatur axial presst und anschließend isostatisch nachverpresst.

14. Verfahren nach Anspruch 11, **dadurch gekennzeichnet, dass** man das Gemisch isostatisch verpresst.

15. Verfahren nach einem oder mehreren der Ansprüche 12 bis 14, **dadurch gekennzeichnet, dass** man als Presshilfsmittel Wachse, Seifen und hochviskose Flüssigkeiten, insbesondere in einer Menge von bis 10 Gew.-Teilen, vorzugsweise 2 bis 6 Gew.-Teilen, bezogen auf das Pulvergemisch einsetzt.

16. Verwendung von keramischen Verdampfermaterialien nach einem oder mehreren der Ansprüche 1 bis 10 zur Beschichtung von Gegenständen, insbesondere im optischen Bereich oder Turbinenbau, insbesondere Flugzeugturbinen oder stationäre Turbinen durch Einwirkung hochenergetischer Strahlung.

17. Verwendung nach Anspruch 16, **dadurch gekennzeichnet, dass** man Turbinenschaufeln, insbesondere Laufschaufeln, von fliegenden Triebwerken oder stationären Gasturbinen beschichtet.

## Claims

1. Ceramic vaporizing materials (ingots) for the coating of objects by means of physical vapor deposition, obtainable by axial pressing, followed by isostatic after-pressing, or by isostatic pressing, of a mixture of at least two powder fractions of from 50 to 90% by volume of a coarse-grained powder and from 10 to 50% by volume of a fine-grained powder at room temperature, wherein the average particle diameter, d₅₀, of said fine-grained powder is at most one third of the average particle diameter of said coarse-grained powder.

2. The ceramic vaporizing materials according to claim 1, **characterized in that** said mixture comprises a coarse-grained powder in an amount of from 60 to 85% by volume and a fine-grained powder in an amount of from 15 to 40% by volume.

3. The ceramic vaporizing materials according to claim 1 or 2, **characterized by** a relative green density of from 50 to 80%, in particular from 70 to 80%.

4. The ceramic vaporizing materials according to one or more of claims 1 to 3, **characterized in that** the average particle diameter, d₅₀, of said fine-grained powder is at most one fifth to one tenth of the particle diameter of said coarse-grained powder.

5. The ceramic vaporizing materials according to one or more of claims 1 to 4, **characterized in that** the absolute particle diameters of said coarse-grained powder exhibit less than 20%, especially less than 10%, of overlapping with the absolute particle diameter of said fine-grained powder.

6. The ceramic vaporizing materials according to one or more of claims 1 to 5, **characterized in that** the chemical composition of said coarse-grained powder is the same as the chemical composition of said fine-grained powder.

7. The ceramic vaporizing materials according to one or more of claims 1 to 5, **characterized in that** the chemical composition of said coarse-grained powder is different from the chemical composition of said fine-grained powder.

8. The ceramic vaporizing materials according to one or more of claims 1 to 7, **characterized in that** the chemical composition of the powders is selected from metal and/or transition metal oxides, nitrides, carbides, borides and/or silicides.

9. The ceramic vaporizing materials according to claim 8, **characterized in that** the powder consists of unstabilized, in particular yttria-free, zirconia.

10. Ceramic vaporizing materials according to claim 8, **characterized in that** the powder consists of alumina.

11. A process for the preparation of ceramic vaporizing materials as claimed in one or more of claims 1 to 10, **characterized in that** mixtures, especially homogeneous ones, of a coarse-grained powder and a fine-grained powder are compression-molded, and the green body obtained is mechanically processed to the desired dimensions.

12. The process according to claim 11, **characterized in that** molding aids are used and that any molding aids present are vaporized by heat treatment at below the onset temperature of sintering.

13. The process according to claim 11 or 12, **characterized in that** said mixture is subjected to axial pressing at room temperature and subsequently to isostatic after-pressing.

14. The process according to claim 11, **characterized in that** said mixture is subjected to isostatic pressing.

15. The process according to one or more of claims 12 to 14, **characterized in that** waxes, soaps and highly viscous liquids are employed as said molding aids, especially in an amount of up to 10 parts by weight, preferably 2 to 6 parts by weight, based on the powder mixture.

16. Use of ceramic vaporizing materials as claimed in one or more of claims 1 to 10 for the coating of objects, especially in the optical field or in turbine construction, in particular jet engines of aircrafts or stationary turbines, by the action of high-energy radiation.

17. The use according to claim 16, **characterized in that** turbine blades, especially guide blades, of turbo-jet engines or stationary gas turbines, are subjected to said coating.

## Revendications

1. Matériaux céramiques à évaporer (lingots) pour revêtir des objets par dépôt physique à partir de la phase gazeuse, **caractérisés en ce qu'**on soumet à une compression axiale à la température ambiante un mélange d'au moins deux fractions de poudre, constituées de 50 à 90 % en volume d'une poudre à granulométrie grossière et de 10 à 50 % en volume d'une poudre à fine granulométrie, le diamètre moyen d₅₀ des particules de la poudre à fine granulométrie étant d'au plus un tiers du diamètre moyen des particules de la poudre à granulométrie grossière, puis **en ce que** l'on soumet le mélange à une post-compression isostatique, ou encore **en ce que** l'on soumet le mélange à une compression isostatique.

2. Matériaux céramiques à évaporer selon la revendication 1, **caractérisés en ce que** le mélange comprend la poudre à granulométrie grossière en une quantité de 60 à 85 % en volume et la poudre à fine granulométrie en une quantité de 15 à 40 % en volume.

3. Matériaux céramiques à évaporer selon la revendication 1 ou 2, **caractérisés en ce que** la densité relative à l'état vert est de 50 à 80 %, en particulier de 70 à 80 %.

4. Matériaux céramiques à évaporer selon une ou plusieurs des revendications 1 à 3, **caractérisés en ce que** le diamètre moyen d₅₀ des particules de la poudre à fine granulométrie est d'au plus un cinquième à un dixième du diamètre des particules de la poudre à granulométrie grossière.

5. Matériaux céramiques à évaporer selon une ou plusieurs des revendications 1 à 4, **caractérisés en ce que** les diamètres absolus des particules de la poudre à granulométrie grossière présentent avec le diamètre absolu des particules de la poudre à fine granulométrie un chevauchement inférieur à 20 % et en particulier inférieur à 10 %.

6. Matériaux céramiques à évaporer selon une ou plusieurs des revendications 1 à 5, **caractérisés en ce que** la composition chimique de la poudre à granulométrie grossière correspond à la composition chimique de la poudre à fine granulométrie.

7. Matériaux céramiques à évaporer selon une ou plusieurs des revendications 1 à 5, **caractérisés en ce que** la composition chimique de la poudre à granulométrie grossière est différente de la composition chimique de la poudre à fine granulométrie.

8. Matériaux céramiques à évaporer selon une ou plusieurs des revendications 1 à 7, **caractérisés en ce que** la composition chimique des poudres est choisie parmi les oxydes, les nitrures, les carbures, les borures et/ou les siliciures de métaux et/ou de métaux de transition.

9. Matériaux céramiques à évaporer selon la revendication 8, **caractérisés en ce que** la poudre est constituée d'un oxyde de zirconium non stabilisé, en particulier exempt d'oxyde d'yttrium.

10. Matériaux céramiques à évaporer selon la revendication 8, **caractérisés en ce que** la poudre est constituée d'oxyde d'aluminium.

11. Procédé de préparation de matériaux céramiques à évaporer selon une ou plusieurs des revendications 1 à 10, **caractérisé en ce qu'**on comprime des mélanges, en particulier homogènes, d'une poudre à granulométrie grossière et d'une poudre à fine granulométrie, et soumet l'ébauche obtenue à un usinage mécanique jusqu'aux dimensions voulues.

12. Procédé selon la revendication 11, **caractérisé en ce qu'**on utilise des auxiliaires de compression et liquéfie les auxiliaires de compression présents, par un traitement thermique en dessous de la température initiale de frittage.

13. Procédé selon la revendication 11 ou 12, **caractérisé en ce qu'**on soumet le mélange à une compression axiale à la température ambiante, puis le soumet à une post-compression isostatique.

14. Procédé selon la revendication 11, **caractérisé en ce qu'**on soumet le mélange à une compression isostatique.

15. Procédé selon une ou plusieurs des revendications 12 à 14, **caractérisé en ce qu'**on utilise en tant qu'auxiliaires de compression des cires, des savons et des liquides à haute viscosité, en particulier en une quantité allant jusqu'à 10 parties en poids, de préférence de 2 à 6 parties en poids par rapport au mélange de poudres.

16. Utilisation de matériaux céramiques à évaporer selon une ou plusieurs des revendications 1 à 10 pour revêtir des objets, en particulier dans le domaine optique ou la construction de turbines, en particulier les turbines pour avions ou les turbines fixes, sous l'action d'un rayonnement à haute énergie.

17. Utilisation selon la revendication 16, **caractérisée en ce qu'**on revêt des aubes de turbine, en particulier des aubes mobiles, de moteurs d'appareils volants ou de turbines à gaz fixes.
